# EUROPEAN PATENT APPLICATION

(11) **EP 1 882 956 A1**
(43) Date of publication of application: **30.01.2008**
(21) Application number: 06729020.5
(22) Date of filing: 14.03.2006
(51) Int. Cl.: G01R 31/28

(54) **TEST DEVICE, TEST METHOD, AND TEST CONTROL PROGRAM**

(30) Priority: 23.03.2005 JP 2005084576
(71) Applicant: ADVANTEST CORPORATION, Nerima-ku, Tokyo 179-0071 (JP)
(72) Inventor: KUMAKI, Norio, ma-ku, Tokyo, 1790071 (JP)
(74) Representative: Pfenning, Meinig & Partner GbR
(86) International application number: PCT/JP2006/304967
(87) International publication number: WO 2006/100959

(57) **Abstract**

It is an object to reduce a failure rate of a semiconductor testing apparatus by decreasing the number of central processing units required for controlling a test.

There is provided a test apparatus that includes: a plurality of test modules that test a plurality of devices under test; and a central processing unit that controls test operations of the plurality of test modules on the basis of a specified operation mode. In this .test apparatus, the central processing unit executes one predetermined test process to control the test operation in each of the plurality of test modules when the specified operation mode is a parallel test mode that causes the plurality of test modules to perform a same test simultaneously and in parallel. On the other hand, the central processing unit executes a plurality of test processes while switching the plurality of test processes from a test process to another test process for the test modules, in order to control the plurality of test modules in parallel when the specified operation mode is an independent test mode that causes the plurality of test modules to independently perform tests different from one another.

## Description

### TECHNICAL FIELD

The present invention relates to a test apparatus, a test method, and a test control program. More particularly, the present invention relates to a test apparatus, a test method, and a test control program for testing a device under test by means of a test process executed by a central processing unit. The present application relates to the following Japanese application, the contents of which are incorporated herein by reference if applicable.
A Japanese Patent Application No. 2005-084576 Filed on March 23, 2005.

### BACKGROUND ART

Conventionally, a semiconductor testing apparatus having a plurality of test modules for testing a plurality of devices under test has been used. This semiconductor testing apparatus has a plurality of central processing units each of which corresponds to each of the plurality of test modules, and each test module is controlled by one central processing unit provided corresponding to this test module. According to this, it is possible to test the plurality of devices under test in parallel and at the same time to raise test efficiency.

Now, since a related patent document is not recognized, the description is omitted.

### DISCLOSURE OF THE INVENTION

### PROBLEMS TO BE SOLVED BY THE INVENTION

Usually, a central processing unit that can be obtained at a relatively low cost as a general-purpose component has an MTBF (Mean Time Between Failure) between 20 years and 30 years. When a singular central processing unit is used or when a few central processing units approximately equal to or less than five are used even if a plurality of central processing units is used, this MTBF is an adequately long time. However, one semiconductor testing apparatus may test around several hundreds of devices under test in parallel and at the same time, and even if a plurality of devices can be tested by one test module, the semiconductor testing apparatus requires at least around one hundred of central processing units.

For example, when one hundred of central processing units are provided in the semiconductor testing apparatus, the MTBF for a whole of these central processing units becomes around 2000 hours to 3000 hours. When considering failure rates of other parts of the semiconductor testing apparatus together, the time cannot be regarded as being adequately large. That is to say, according to the configuration, a failure rate of the semiconductor testing apparatus may increase, and thus its utility may become a problem. On the other hand, a recent central processing unit has high performance at an adequately low cost. Therefore, although one central processing unit controls one test module, the central processing unit may have surplus processing capacity.

Therefore, it is an object of the present invention to provide a test apparatus, a test method, and a test control program that can solve the foregoing problems. The above and other objects can be achieved by combinations described in the independent claims. The dependent claims define further advantageous and exemplary combinations of the present invention.

### MEANS FOR SOLVING THE PROBLEMS

To solve the above-described problem, according to the first aspect of the present invention, there is provided a test apparatus that tests a plurality of devices under test. The test apparatus includes: a plurality of test modules that are connected to the plurality of devices under test and test the plurality of devices under test; and a central processing unit that controls test operations of the plurality of test modules on the basis of a specified operation mode, in which the central processing unit: executes one predetermined test process to control the test operation in each of the plurality of test modules when the specified operation mode is a parallel test mode that causes the plurality of test modules to perform a same test simultaneously and in parallel; and executes a plurality of test processes that controls the plurality of test modules in a one-to-one correspondence while switching the plurality of test processes from a test process to another test process, in order to control the plurality of test modules in parallel when the specified operation mode is an independent test mode that causes the plurality of test modules to independently perform tests different from one another.

Moreover, each of the plurality of test modules may perform, when being controlled by the corresponding test process, a test operation based on contents of this control, and the central processing unit may finish executing a first of the test processes corresponding to a first of the test modules in preference to executing a second of the test processes corresponding to a second of the test modules and control the second test module in a state where the first test module performs a test operation, in a state where both of the first test module and the second test module wait for controls by the corresponding test processes when the specified operation mode is the independent test mode.

Moreover, the central processing unit may execute the second test process in place of the first test process while the first test process accesses the first test module and is in a wait state.
Moreover, the central processing unit may resume execution of the first test process in place of execution of the second test process when the first test process terminates accessing the first test module.

According to the second aspect of the present invention, there is provided a test method for testing a plurality of devices under test by a test apparatus that tests the plurality of devices under test. The test apparatus includes: a plurality of test modules that are connected to the plurality of devices under test and test the plurality of devices under test; and a central processing unit that controls test operations of the plurality of test modules on the basis of a specified operation mode, and the test method causes the central processing unit to: execute one predetermined test process to control the test operation in each of the plurality of test modules when the specified operation mode is a parallel test mode that causes the plurality of test modules to perform a same test simultaneously and in parallel; and execute a plurality of test processes that controls the plurality of test modules in a one-to-one correspondence while switching the plurality of test processes from a test process to another test process, in order to control the plurality of test modules in parallel when the specified operation mode is an independent test mode that causes the plurality of test modules to independently perform tests different from one another.

According to the third aspect of the present invention, there is provided a test control program for controlling a test apparatus that tests a plurality of devices under test. The test apparatus includes: a plurality of test modules that are connected to the plurality of devices under test and test the plurality of devices under test; and a central processing unit that controls test operations of the plurality of test modules on the basis of a specified operation mode, and the test control program causes the central processing unit to: execute one predetermined test process to control the test operation in each of the plurality of test modules when the specified operation mode is a parallel test mode that causes the plurality of test modules to perform a same test simultaneously and in parallel; and execute a plurality of test processes that controls the plurality of test modules in a one-to-one correspondence while switching the plurality of test processes from a test process to another test process, in order to control the plurality of test modules in parallel when the specified operation mode is an independent test mode that causes the plurality of test modules to independently perform tests different from one another.

### EFFECT OF THE INVENTION

According to the present invention, it is possible to reduce a failure rate of a semiconductor testing apparatus by decreasing the number of central processing units required for controlling a test.

The summary of the invention does not necessarily describe all necessary features of the present invention. The present invention may also be a sub-combination of the features described above.

### BRIEF DESCRIPTION OF THE DRAWINGS

FIG. 1 is a view showing a configuration of a test apparatus 10 when the test apparatus 10 operates in a parallel test mode.
FIG. 2 is a view showing a configuration of the test apparatus 10 when the test apparatus 10 operates in an independent test mode.
FIG. 3 is a view showing a timing diagram of control phases and test operation phases in the parallel test mode.
FIGs. 4A and 4B are views showing timing diagrams of control phases and test operation phases in the independent test mode.

### REFERENCE NUMERALS

- 10: test apparatus
- 20: test module
- 25: device under test
- 30: central processing unit
- 35: test process
- 38: test process

### BEST MODE FOR CARRYING OUT THE INVENTION

The invention will now be described based on the preferred embodiments, which do not intend to limit the scope of the present invention, but exemplify the invention. All of the features and the combinations thereof described in the embodiments are not necessarily essential to the invention.

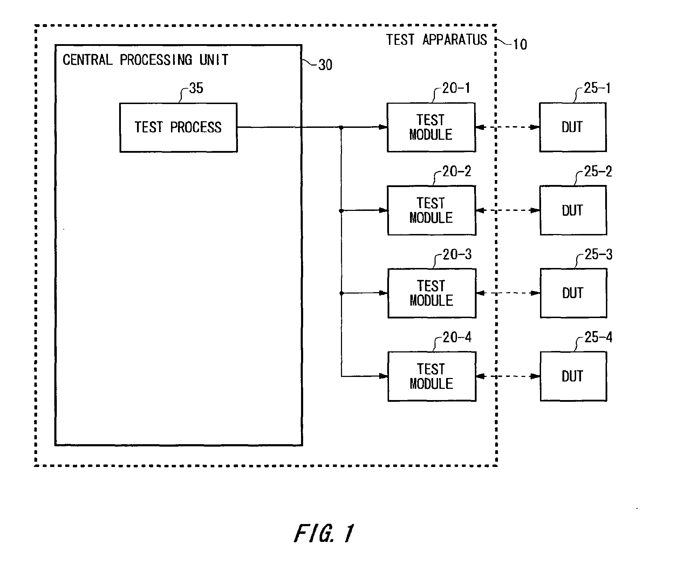

FIG. 1 is a view showing a configuration of a test apparatus 10 when the test apparatus 10 operates in a parallel test mode. The test apparatus 10 includes test modules 20-1 to 20-4 and a central processing unit 30. The test modules 20-1 to 20-4 are connected to devices under test (DUT : Device Under Test) 25-1 to 25-4, and test these devices under test 25-1 to 25-4. For example, the respective test modules 20-1 to 20-4 are connected to the respective devices under test 25-1 to 25-4 one by one, and test the corresponding devices under test.

The central processing unit 30 controls test operations of the test modules 20-1 to 20-4 on the basis of a specified operation mode. For example, the present drawing shows the configuration when the specified operation mode is a parallel test mode in which the plurality of test modules simultaneously perform the same test in parallel. That is to say, in this case, the central processing unit 30 executes a test process 35 that is one predetermined test process, in order to control the test operations performed by the respective test modules 20-1 to 20-4. A detailed processing matter for the control is as follows. The test process 35 sends, for example, parameters required for the test operations to the respective test modules 20-1 to 20-4 at the same time, and sets the parameters in the respective test modules 20-1 to 20-4. Then, the test process 35 may collect test results obtained by the test operations performed in the respective test modules 20-1 to 20-4 in order to judge pass/fail of the devices under test 25-1 to 25-4.

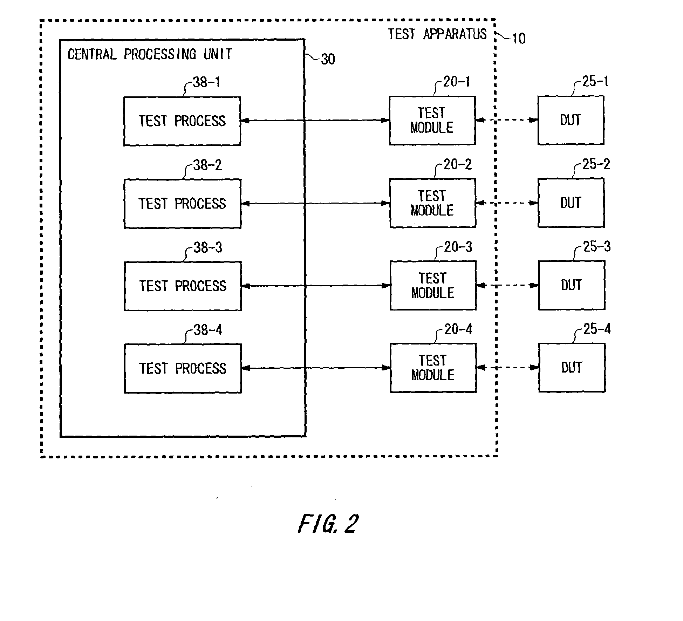

FIG. 2 is a view showing a configuration of the test apparatus 10 when the test apparatus 10 operates in an independent test mode. Similarly to the configuration shown in FIG. 1, the test apparatus 10 includes the test modules 20-1 to 20-4 and the central processing unit 30. The test modules 20-1 to 20-4 are connected to the devices under test 25-1 to 25-4, and test the devices under test 25-1 to 25-4. When the specified operation mode is an independent test mode in which each of the plurality of test modules independently performs a different test, the central processing unit 30 performs the next process.

First, the central processing unit 30 executes, for each of the test modules, a test process that controls this test module. That is to say, the central processing unit 30 executes each of test processes 38-1 to 38-4 in association with each of the test modules 20-1 to 20-4. Then, the central processing unit 30 executes each of the test processes 38-1 to 38-4 while switching each of the test processes from a test process to another test process, in order to control the test modules 20-1 to 20-4 in parallel. In addition, the respective test processes 38-1 to 38-4 independently control the respective test modules 20-1 to 20-4, but one common control line such as a PCI bus may be used for the controls.

Here, the tests controlled by the respective test processes 38-1 to 38-4 are different from one another. For example, the different tests correspond to different types of the devices under test to be judged. Alternatively, although the types of the devices under test are equal to one another, the different tests may correspond to different contents to be judged. Further, although the contents to be judged are equal to one another, the different tests may correspond to different times from a start of each test to its termination.

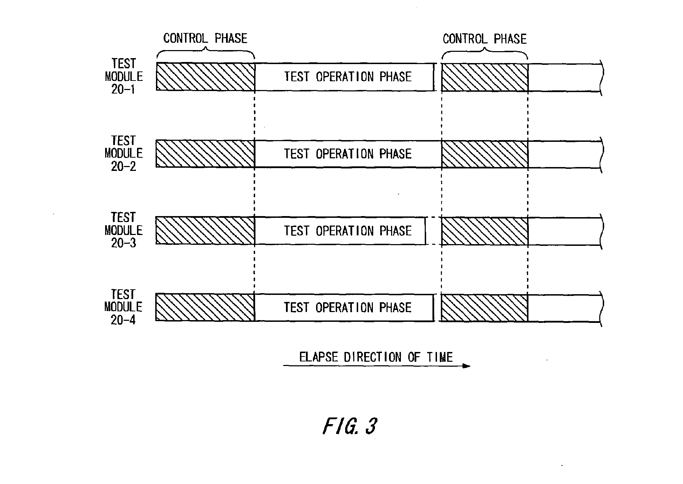

FIG. 3 is a view showing a timing diagram of control phases and test operation phases in the parallel test mode. Each of the test modules 20-1 to 20-4 is controlled by the test process 35. As an example, the test modules 20-1 to 20-4 respectively write the parameter received from the test process 35 into registers within the test modules. The series of operations in which a parameter is received and then the received parameter is written into a register are referred to as a control phase. Since the test modules 20-1 to 20-4 are performed on the basis of the same parameter received from the test process 35 together, the control phase is performed in the respective test modules 20-1 to 20-4 at the same time and in parallel.

Then, when each of the test modules 20-1 to 20-4 is controlled by the test process 35, the test modules perform a test operation based on contents of the control. This test operation is referred to as a test operation phase. For example, each of the test modules 20-1 to 20-4 may output, in a test operation phase, test patterns to each of the devices under test 25-1 to 25-4 and collect output patterns output from the devices under test 25-1 to 25-4 in accordance with the test patterns.

As shown in the present drawing, in a control phase of the parallel test mode, only the test process 35 operates on the central processing unit 30, and the test modules 20-1 to 20-4 are together controlled by the test process 35 at the same time. For this reason, the control phase is quickly terminated regardless of the number of the test modules, and a test operation phase is started promptly. In this manner, according to the parallel test mode, it is possible to increase efficiency because a control phase is finished within a short time.

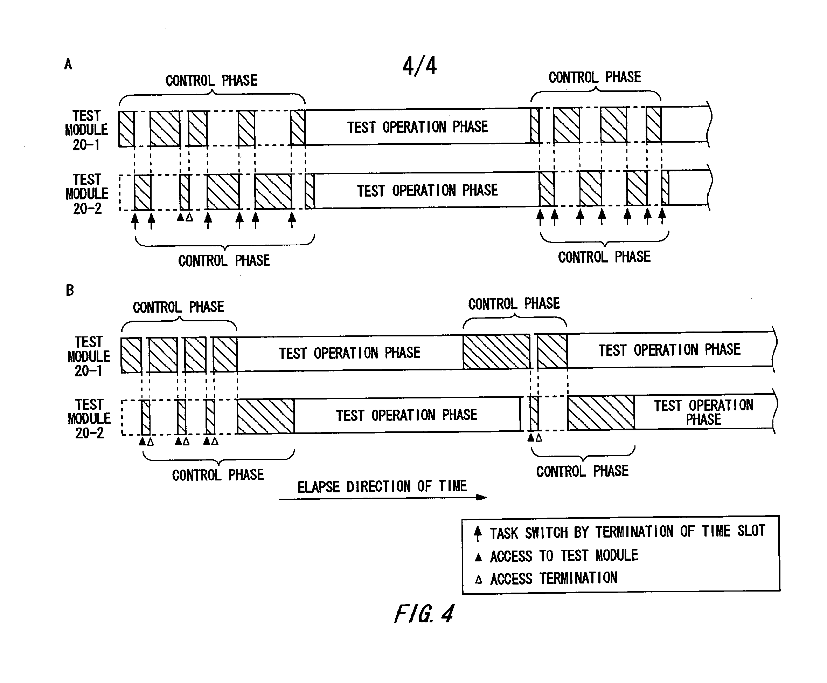

FIG. 4A is a view showing a timing diagram of control phases and test operation phases in the independent test mode (the first example). For convenience of description, it will be described about only the test modules 20-1 to 20-2 among the test modules 20-1 to 20-4. It is assumed that the test module 20-1 is an example of the first test module according to the present invention, and the test module 20-2 is an example of the second test module according to the present invention. At the time instant of the left end in the drawing, all of the test module 20-1 and the test module 20-2 are in a state waiting for the controls by the corresponding test processes 38-1 and 38-2.

The test module 20-1 is controlled by the test process 38-1, and the test module 20-2 is controlled by the test process 38-2. The central processing unit 30 executes the test process 38-1 and the test process 38-2. Strictly speaking, since the central processing unit 30 cannot simultaneously execute two or more processes, the central processing unit executes the test process 38-1 and the test process 38-2 by switching them from a test process to another test process, in order to control the central processing unit 30-1 and the central processing unit 30-2 in parallel. When the switching between the processes depends on a function of an OS (operating system), the OS usually assigns a time slot having a predetermined time interval to each process.

That is to say, since a time slot is terminated when a predetermined time has passed after starting a process operation, a process is switched to another process. Moreover, when a process becomes an input-output wait state (for example, when a test process accesses a test module) even if a time slot is not terminated, the OS switches the process to another process. In a normal application, these procedures are important in that a processing speed among the processes is equalized and responsiveness of the processes is improved.

However, the test modules in the present embodiment are controlled by the processes only in the control phase, and independently perform test operations without being controlled by the processes after the control phase is terminated. For this reason, it is highly efficient when the number of the test modules waiting for the termination of the control phase is as less as possible. Thus, the test apparatus 10 in the present embodiment preferably performs a test at a timing shown in the next second example.

FIG. 4B is a view showing a timing diagram of control phases and test operation phases in the independent test mode (the second example). Similarly to FIG. 4A, the test module 20-1 is controlled by the test process 38-1, and the test module 20-2 is controlled by the test process 38-2. The central processing unit 30 executes the test process 38-1 and the test process 38-2 while switching them from a test process to another test process, in order to control the central processing unit 30-1 and the central processing unit 30-2 in parallel. Moreover, at the time instant of the left end in the drawing, all of the test module 20-1 and the test module 20-2 are in a state waiting for the controls by the corresponding test processes 38-1 and 38-2.

Unlike FIG. 4A, the central processing unit 30 in the present drawing causes the test process 38-1 corresponding to the test module 20-1 to previously complete its execution in preference to an execution of the test process 38-2 corresponding to the test module 20-2. Then, when the execution of the test process 38-1 is completed, the central processing unit 30 executes the test process 38-2 to control the test module 20-2 in the state where the test module 20-1 performs the test operation.

However, when the prioritized process waits for an input or an output, a continuous execution of the prioritized process gives rise to bad efficiency. Thus, the central processing unit 30 executes the test process 38-2 in place of the test process 38-1 while the test process 38-1 accesses the test module 20-1 and becomes a wait state. Then, the central processing unit 30 resumes the execution of the test process 38-1 in place of the execution of the test process 38-2 when the test process 38-1 terminates its access to the test module 20-1.

In addition, since a concrete implementation method for preferentially executing a certain process and an implementation method for switching an execution from an input-output wait process to another process have been conventionally known in a technical field related to a scheduler of an operating system, the description is omitted. As described above, according to the procedure shown in the present drawing, it is possible to start the test operation phases as soon as possible and complete the control phases as soon as possible by effectively using input-output wait time.

Although the present invention has been described by way of an exemplary embodiment, it should be understood that those skilled in the art might make many changes and substitutions without departing from the spirit and the scope of the present invention. It is obvious from the definition of the appended claims that embodiments with such modifications also belong to the scope of the present invention.

## Claims

1. A test apparatus that tests a plurality of devices under test, comprising:
a plurality of test modules that are connected to the plurality of devices under test and test the plurality of devices under test; and
a central processing unit that controls test operations of the plurality of test modules on the basis of a specified operation mode, wherein
the central processing unit:
executes one predetermined test process to control the test operation in each of the plurality of test modules when the specified operation mode is a parallel test mode that causes the plurality of test modules to perform a same test simultaneously and in parallel; and
executes a plurality of test processes that controls the plurality of test modules in a one-to-one correspondence while switching the plurality of test processes from a test process to another test process, in order to control the plurality of test modules in parallel when the specified operation mode is an independent test mode that causes the plurality of test modules to independently perform tests different from one another.

2. The test apparatus as claimed in claim 1, wherein
each of the plurality of test modules performs, when being controlled by the corresponding test process, a test operation based on contents of said control, and
the central processing unit finishes executing a first of the test processes corresponding to a first of the test modules in preference to executing a second of the test processes corresponding to a second of the test modules and controls the second test module in a state where the first test module performs a test operation, in a state where both of the first test module and the second test module wait for controls by the corresponding test processes when the specified operation mode is the independent test mode.

3. The test apparatus as claimed in claim 2, wherein the central processing unit executes the second test process in place of the first test process while the first test process accesses the first test module and is in a wait state.

4. The test apparatus as claimed in claim 3, wherein the central processing unit resumes execution of the first test process in place of execution of the second test process when the first test process terminates accessing the first test module.

5. A test method for testing a plurality of devices under test by a test apparatus that tests the plurality of devices under test,
the test apparatus comprising:
a plurality of test modules that are connected to the plurality of devices under test and test the plurality of devices under test; and
a central processing unit that controls test operations of the plurality of test modules on the basis of a specified operation mode, and
the test method causing the central processing unit to:
execute one predetermined test process to control the test operation in each of the plurality of test modules when the specified operation mode is a parallel test mode that causes the plurality of test modules to perform a same test simultaneously and in parallel; and
execute a plurality of test processes that controls the plurality of test modules in a one-to-one correspondence while switching the plurality of test processes from a test process to another test process, in order to control the plurality of test modules in parallel when the specified operation mode is an independent test mode that causes the plurality of test modules to independently perform tests different from one another.

6. A test control program for controlling a test apparatus that tests a plurality of devices under test,
the test apparatus comprising:
a plurality of test modules that are connected to the plurality of devices under test and test the plurality of devices under test; and
a central processing unit that controls test operations of the plurality of test modules on the basis of a specified operation mode, and
the test control program causing the central processing unit to:
execute one predetermined test process to control the test operation in each of the plurality of test modules when the specified operation mode is a parallel test mode that causes the plurality of test modules to perform a same test simultaneously and in parallel; and
execute a plurality of test processes that controls the plurality of test modules in a one-to-one correspondence while switching the plurality of test processes from a test process to another test process, in order to control the plurality of test modules in parallel when the specified operation mode is an independent test mode that causes the plurality of test modules to independently perform tests different from one another.

7. A recording medium storing thereon a test control program controlling a test apparatus that tests a plurality of devices under test,
the test apparatus comprising:
a plurality of test modules that are connected to the plurality of devices under test and tests the plurality of devices under test; and
a central processing unit that controls test operations of the plurality of test modules on the basis of a specified operation mode, and
the test control program causing the central processing unit to:
execute one predetermined test process to control the test operation in each of the plurality of test modules when the specified operation mode is a parallel test mode that causes the plurality of test modules to perform a same test simultaneously and in parallel; and
execute a plurality of test processes that controls the plurality of test modules in a one-to-one correspondence while switching the plurality of test processes from a test process to another test process, in order to control the plurality of test modules in parallel when the specified operation mode is an independent test mode that causes the plurality of test modules to independently perform tests different from one another.
